(19) Europäisches Patentamt / European Patent Office / Office européen des brevets

(11) **EP 3 389 181 B1**

(12) **EUROPÄISCHE PATENTSCHRIFT**

(45) Veröffentlichungstag und Bekanntmachung des Hinweises auf die Patenterteilung:
**24.02.2021  Patentblatt 2021/08**

(51) Int Cl.:
*H03F 1/02* *(2006.01)*        *H03F 1/32* *(2006.01)*
*H03F 1/34* *(2006.01)*        *H03F 3/193* *(2006.01)*

(21) Anmeldenummer: **17165827.1**

(22) Anmeldetag: **10.04.2017**

(54) **VORRICHTUNG UND VERFAHREN ZUR STROMREGELUNG DURCH EINEN TRANSISTOR**

DEVICE AND METHOD FOR CONTROLLING CURRENT THROUGH A TRANSISTOR

DISPOSITIF ET PROCÉDÉ DE CONTRÔLE DE COURANT DANS UN TRANSISTOR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**17.10.2018  Patentblatt 2018/42**

(73) Patentinhaber: **HENSOLDT Sensors GmbH**
**82024 Taufkirchen (DE)**

(72) Erfinder:
• **Wedemeyer, Markus**
**85764 Oberschleißheim (DE)**
• **Sledzik, Hardy Hans**
**89134 Blaustein (DE)**

(74) Vertreter: **LifeTech IP**
**Spies & Behrndt Patentanwälte PartG mbB**
**Elsenheimerstraße 47a**
**80687 München (DE)**

(56) Entgegenhaltungen:
**WO-A1-03/063342        WO-A1-2017/044657**
**US-A1- 2003 155 978**

EP 3 389 181 B1

## Beschreibung

Die vorliegende Erfindung bezieht sich auf eine Vorrichtung und ein Verfahren zur Regelung eines Stromes durch einen Transistor und insbesondere auf eine Ruhestromregelung von Galliumnitrid (GaN)-Transistoren zur Eliminierung von sogenannten Memoryeffekten.

### Hintergrund

Bei Transistoren kann es vorkommen, dass die Übertragung eines aktuellen Signals von der Übertragung eines zeitlich vorherigen Signals abhängt. Dieser sogenannte Memoryeffekt ist häufig bei Galliumnitrid-Transistoren anzutreffen. So sind Pulsverstärker, wie sie zum Beispiel in Systemen zur Freund-Feind-Erkennung eingesetzt werden, diesem Problem häufig ausgesetzt - insbesondere dann, wenn Pulse mit unterschiedlichen Amplituden nacheinander übertragen werden sollen. Als Folge hängt beispielsweise die Amplituden eines Signals A2 zum Zeitpunkt t2 von der Amplitude eines zuvor übertragenen Signals A1 zum Zeitpunkt t1 ab (t1<t2). Da in solchen Systemen die Amplituden möglichst unverfälscht sein sollen, ist dies nicht akzeptabel und es besteht ein Bedarf nach Regelungen oder Schaltungsanordnungen, die diesen Memoryeffekt effizient beseitigen.

US 2003/0155978 A1 offenbart eine bekannte Steuerung für eine Vorspannung, die dynamisch für einen Leistungsverstärker vorgenommen werden kann. Weitere bekannte Verfahren sind offenbart in WO 03/063342 A1 (Verfahren und eine Schaltung zur Steuerung eines Leistungsverstärkers) und in WO 2017/044657 A1 (automatische Vorspannungssteuerung für einen gepulsten Leistungsverstärker).

### Zusammenfassung

Zumindest ein Teil der obengenannten Probleme wird durch einen Pulsverstärker nach Anspruch1 und ein Verfahren nach Anspruch 7 gelöst. Die abhängigen Ansprüche definieren weitere vorteilhafte Ausführungsformen der vorliegenden Erfindung.

### Kurzbeschreibung der Figuren

Die Ausführungsbeispiele der vorliegenden Erfindung werden besser verstanden anhand der folgenden detaillierten Beschreibung und den beiliegenden Zeichnungen der unterschiedlichen Ausführungsbeispiele, die jedoch nicht so verstanden werden sollten, dass sie die Offenbarung auf die spezifischen Ausführungsformen einschränken, sondern lediglich der Erklärung und dem Verständnis dienen.

Fig. 1     zeigt eine Vorrichtung zur Ruhestromregelung in einer Transistorschaltung.

Fig. 2     zeigt weitere Details einer Regelschaltung gemäß einem Ausführungsbeispiel der vorliegenden Erfindung.

Fig. 3     zeigt ein Flussdiagramm für ein Verfahren zur Ruhestromregelung.

### Detaillierte Beschreibung

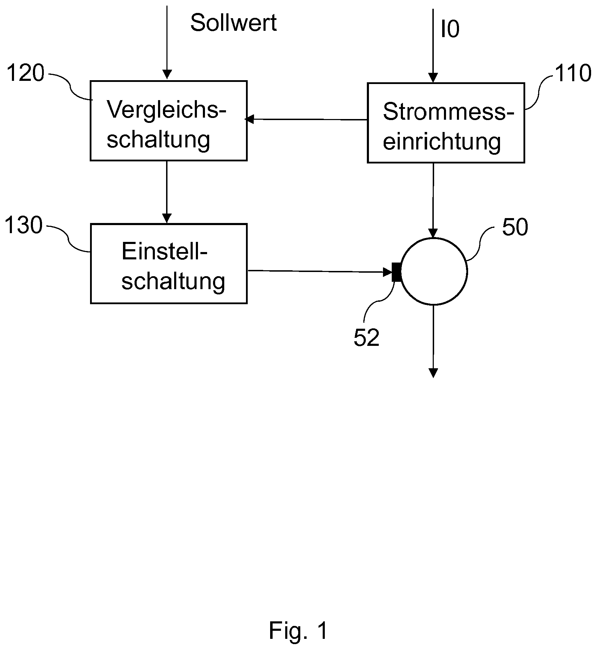

**Fig. 1** zeigt eine Vorrichtung die geeignet ist, um einen Stromes Io durch einen Transistor 50 in einem Ruhezustand zu regeln, wobei der Transistor 50 einen Steueranschluss 52 (Gate) aufweist. Die Vorrichtung umfasst eine Strommesseinrichtung 110 zum Erfassen einer Messgröße, die von dem Strom Io durch den Transistor 50 abhängt, und eine Vergleichsschaltung 120 zum Vergleichen der erfassten Messgröße mit einem Sollwert. Außerdem umfasst die Vorrichtung eine Einstellschaltung 130, die ausgebildet ist, um in Abhängigkeit von dem Vergleich in dem Ruhezustand des Transistors 50 einen Spannungswert oder einen Stromwert an dem Steueranschluss 52 anzulegen. Der angelegte Spannungswert oder Stromwert ist so gewählt, dass der (Ruhe-) Strom Io durch den Transistor 50 in dem Ruhezustand einen gewünschten Wert aufweist.

Der Transistor 50 ist ein Galliumnitrid-Transistor, wobei der Arbeitspunkt über eine feste Gate-Spannung einstellbar ist. Der Arbeitspunkt selbst wird über einen Ruhestrom Io eingestellt, wobei der Ruhestrom Io der elektrische Strom ist, der in Abwesenheit einer Signalübertragung durch den Transistor 50 zwischen Source (Quelle; z.B. stromaufwärts vom Transistor 50) und Drain (Senke; z.B. stromabwärts vom Transistor 50) fließt. Infolge des eingangs beschriebenen Memoryeffektes kann sich jedoch dieser Arbeitspunkt bzw. der Ruhestrom in Abhängigkeit von einem übertragenen Signal (z.B. ein Hochfrequenzsignal) ändern. Das hätte zur Folge, dass sich die Verstärkung oder das Verhalten des Transistors 50 mit der Zeit ändert. Daher ist die feste Einstellung des Arbeitspunktes (d.h. ohne eine Nachregelung), wie es bei konventionellen Transistorschaltungen geschieht, nachteilig.

Ausführungsbeispiele überwinden diesen Nachteil durch ein Nachregeln des Arbeitspunktes für den Transistor. Insbesondere kann dieses Nachregeln in Signalpausen oder vor jeder Signalübertragung erfolgen. Wie bereits dargelegt wird in einem Regelkreis der Strom durch den Transistor 50 fortlaufend gemessen und mit einem Sollwert verglichen.

Darauf basierend wird anschließend ein Spannungs- oder Stromwert an dem Steueranschluss 52 entsprechend eingestellt/nachjustiert.

Auf diese Weise wird der Arbeitspunkt stets von neuem nachgestellt und wird das Problem des Memoryeffektes vermieden.

Ausführungsbeispiele bieten daher den Vorteil, dass ein definierten Arbeitspunkt - unabhängig von einem zuvor übertragenen Signal - bereitgestellt wird. Somit wird ein konstanter (signalunabhängiger) Ruhestrom durch den Transistor 50 sichergestellt. Der Transistor 50 wird somit immer auf seine Standardwerte zurückgesetzt -Änderungen, die durch die Signalübertragung verursacht wurden, können auf diese Weise eliminiert werden.

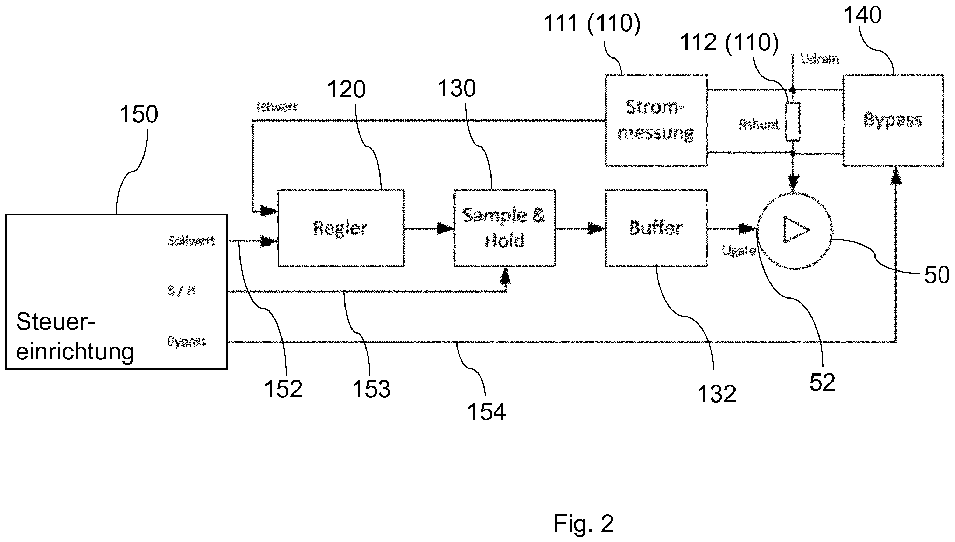

**Fig. 2** zeigt ein Ausführungsbeispiel für die genannte Ruhestromregelung durch den Transistor 50.

In dem gezeigten Ausführungsbeispiel umfasst die Strommesseinrichtung 110 einen Strommesser 111 und einen Shunt-Widerstand 112. Der Shunt-Widerstand 112 kann durch die Überbrückungsschaltung 140 (Bypass) überbrückt werden. Der Strommesser 111 liefert einen Istwert, der in einem Regler (Vergleichsschaltung 120) eingegeben wird. Der Regler 120 vergleicht den Istwert mit einem Sollwert. Das Resultat wird einer Sample-und-Hold-Schaltung (Einstellschaltung 130) zugeführt, die wiederum über einen Verstärker 132 (z.B. Puffer-Verstärker) die Gate-Spannung Ugate an dem Steueranschluss 52 des Transistors 50 einstellt.

Außerdem ist in der Erfindung eine Steuereinrichtung 150 vorgesehen, die den Sollwert über eine erste Signalleitung 152 dem Regler 120 zur Verfügung stellt. Die Steuereinrichtung 150 ist außerdem ausgebildet, um über eine zweite Signalleitung 153 die Sample-und-Hold-Schaltung 130 entweder in einen Haltemodus oder in einen Änderungsmodus zu setzen. Schließlich ist die Steuereinrichtung 150 ausgebildet, um ein Bypass-Signal über eine dritte Signalleitung 154 an die Überbrückungsschaltung 140 zu senden.

In dem Änderungsmodus unterbricht die Steuereinrichtung 150 zunächst die Überbrückungsschaltung 140, so dass der Strom Io in den Transistor 50 über den Shunt-Widerstand 112 fließt. Der Shunt-Widerstand 112 hat einen vorgegebenen Widerstandswert Rshunt, der zu einem Spannungsabfall führt, der proportional zu dem Strom Io durch den Transistor 50 ist. Dieser Spannungsabfall kann durch den Strommesser 111 gemessen und als Istwert an den Regler 120 weitergegeben werden. Der Regler 120 vergleicht diesen Istwert mit dem durch die Steuereinrichtung 150 bereitgestellten Sollwert. Falls der Istwert und der Sollwert sich (zumindest) um einen vorbestimmten Schwellenwert voneinander unterscheiden, veranlasst der Regler 120 (oder die Steuereinrichtung 150) die Sample-und-Hold-Schaltung 130 eine Anpassung für einen Stromwert oder Spannungswert vorzunehmen. Der angepasste Stromwert/Spannungswert wird dem Puffer-Verstärker 132 zugeführt und nach einer Verstärkung als neue Spannung Ugate (oder neuen Strom) an den Steueranschluss 52 des Transistors 50 angelegt. Diese Regelung kann solange ausgeführt werden, bis das gewünscht Ziel erreicht ist, d.h. der Soll- und Istwert sich bis auf einen Toleranzwert angenähert haben. Dazu kann der Regler 120 beispielsweise eine entsprechende Information an die Steuereinheit 150 senden (z.B. über eine Leitung, die nicht gezeigt ist) und die Steuereinheit 150 kann daraufhin den Änderungsmodus beenden und in einem zweiten Arbeitsmodus gehen.

In dem zweiten Arbeitsmodus betreibt die Steuereinrichtung 150 die gezeigte Vorrichtung in einem Haltemodus. Dazu wird über die zweite Steuerleitung 153 die Sample-und-Hold-Schaltung 130 in einen Haltezustand gebracht, der dazu führt, dass der zuvor eingestellte Spannungs- oder Stromwert an dem Steueranschluss 52 zumindest in Ruhezuständen aufrechterhalten wird. Das führt dazu, dass der Ruhestrom durch den Transistor 50 sich nicht ändern kann. In einem folgenden Betriebsmodus kann sich natürlich die Spannung am Steueranschluss 52 des Transistors 50 in Abhängigkeit der Signalverarbeitung ändern. Dies kann über eine weitere Signalleitung geschehen, die in der Fig. 2 nicht gezeigt ist.

Die beschriebene Kalibrierung des Ruhestromes Io wird durch die Steuereinrichtung 150 beispielsweise in periodischen Abständen ausgelöst. Es ist ebenfalls möglich, dass eine oder jede bevorstehende Signalübertragung die Steuereinrichtung 150 veranlasst, zunächst den Änderungsmodus auszulösen, um eine Justierung des Ruhestromes auszuführen, und zwar bevor die anstehende Signalübertragung durchgeführt wird. Dazu können entsprechende Triggersignale an die Steuereinrichtung 150 gesandt werden oder die Steuereinrichtung 150 kennt im Voraus die Häufigkeit/Zeitpunkte der Signalübertragungen und kann dementsprechend die Nachregelung veranlassen. Dadurch wird vor jeder Signalübertragung, die Steuereinrichtung 150 die Vorrichtung in den Änderungsmodus setzt und ein(e) Anpassung/Zurücksetzen des Ruhestromes Io durchführt.

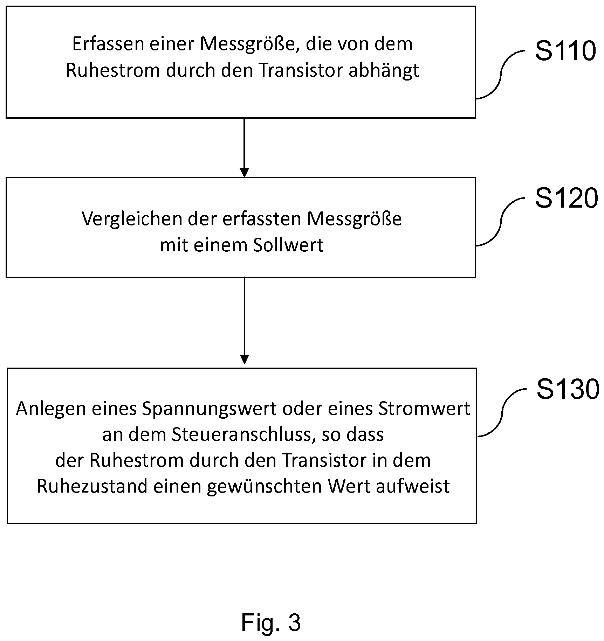

**Fig. 3** zeigt ein Flussdiagramm für ein Verfahren zur Regelung eines Ruhestromes durch den Transistor 50 mit dem Steueranschluss 52. Das Verfahren umfasst die folgenden Schritte:

- Erfassen S110 einer Messgröße, die von dem Ruhestrom durch den Transistor abhängt;
- Vergleichen S120 der erfassten Messgröße mit einem Sollwert; und
- Anlegen S130 eines Spannungswert oder eines Stromwert an dem Steueranschluss, so dass der Ruhestrom durch den Transistor in dem Ruhezustand einen gewünschten Wert aufweist.

Der Schritt des Anlegens S130 kann in einem Ruhezustand des Transistors 50 und/oder in Abhängigkeit von dem Vergleichen S120 erfolgen. Das Verfahren kann fortlaufend als ein Regelkreis ausgeführt werden, bis eine Abweichung der erfassten Messgröße von dem Sollwert innerhalb eines Toleranzbereiches liegt. Wie zuvor dargelegt, kann das Verfahren regelmäßig (z.B. vor einer anstehenden Signalübertragung) wiederholt werden. Es sollte aber nicht während der regulären Signalübertragung durchgeführt werden, da ansonsten eine Signalverstärkung negativ beeinflusst wird.

Das Prinzip der Ruhestromregelung kann wie folgt zusammengefasst werden:
Die Schaltung zur Stromregelung besteht aus einem Regler (Vergleichsschaltung 120), einer Sample & Hold-Schaltung (Einstellschaltung 130) mit einem optional nachgeschalteten Pufferverstärker 132, einem Netzwerk zur Strommessung (Strommesseinrichtung 110) und einer Bypass-Schaltung 140. Die Spannung Ugate am Ausgang des beispielhaften Puffer-Verstärkers 132 geht auf den Steueranschluss 52 des angeschlossenen Transistors 50. Die Drain-Spannung Udrain wird über einen Widerstand 112 (Shunt-Widerstand Rshunt), über den der Strom Io durch den Transistor 50 gemessen werden kann, an den Transistor 50 angelegt. Das Netzwerk 110 zur Strommessung setzt den aktuell fließenden Strom in einen Spannungswert um (Istwert). Der Istwert wird im Regler 120 mit dem Sollwert verglichen. Die Ausgangsspannung des Reglers 120 geht im Sample-Modus (Änderungsmodus) über den Puffer-Verstärker 132 auf das Gate des Transistors 50 und stellt damit den Drain-Strom ein. Der Puffer-Verstärker 132 liefert dabei den nötigen Gate-Strom, der im Sättigungsbetrieb des Transistors 50 fließen kann. Die Gate-Spannung Ugate ändert sich beispielsweise solange bis der Istwert für den Ruhestrom gleich dem Sollwert ist. Für den Sollwert des Ruhestroms gilt:

$$IDsoll = Sollwert/Rshunt.$$

Wenn der Sollwert für den Ruhestrom Io eingestellt ist, wird die Sample & Hold-Schaltung 130 in den Hold-Modus (Haltemodus) gesetzt. Der Regelkreis ist damit unterbrochen und eine feste Gate-Spannung Ugate liegt über dem Puffer-Verstärker 132 an dem Gate 52 des Transistors 50 an. Damit wird vermieden, dass der Regler 120 einen HF-Arbeitsstrom bei HF-Verstärkung des Transistors 50 ausregelt (auf die Größe des Ruhestromes Io), was eine Verstärkung verhindern würde. Die Bypass-Schaltung 140 überbrückt schließlich den Shunt-Widerstand 112, um einen hohen Spannungsabfall zu vermeiden, wenn bei regulärer Aussteuerung ein hoher Arbeitsstrom fließt.

Bezugszeichenliste

| | |
|---|---|
| 50 | Transistor |
| 52 | Steueranschluss |
| 110 | Strommesseinrichtung |
| 111 | Spannungsmesseinheit |
| 112 | Shunt-Widerstand |
| 120 | Vergleichsschaltung |
| 130 | Einstellschaltung |
| 132 | Verstärker |
| 140 | Bypass-Schaltung |
| 150 | Steuereinrichtung |
| 152 | erste Signalleitung für den Sollwert |
| 153 | zweite Signalleitung für Sample/Hold-Signal |
| 154 | dritte Signalleitung für Überbrückungssignal |
| Io | Ruhestrom |

**Patentansprüche**

1. Pulsverstärker mit zumindest einem Galliumnitridtransistor (50) mit einem Drain-Anschluss, einem Source-Anschluss und einem Gate-Anschluss als Steueranschluss (52), worin der Pulsverstärker ausgebildet ist, um aufeinanderfolgende Pulse mit variabler Amplitude zu verstärken, und zur Eliminierung von Memoryeffekten eine Vorrichtung zur Regelung eines Ruhestromes (Io) durch den Galliumnitridtransistor (50) aufweist, die Vorrichtung umfasst die folgenden Merkmale:

   eine Strommesseinrichtung (110) zum Erfassen einer Messgröße, die von dem Ruhestrom (Io) durch den Galliumnitridtransistor (50) zwischen einem Drain-Anschluss und dem Source-Anschluss abhängt;
   eine Vergleichsschaltung (120) zum Vergleichen der erfassten Messgröße mit einem Sollwert;
   eine Einstellschaltung (130), die in einem Änderungsmodus und in einem Haltemodus betreibbar ist und ausgebildet ist, um in einem Ruhezustand des Galliumnitridtransistors (50) in Abhängigkeit von dem Vergleich einen Spannungswert oder einen Stromwert an dem Steueranschluss (52) anzulegen, so dass der Ruhestrom (Io) durch den Galliumnitridtransistor (50) in dem Ruhezustand einen gewünschten Wert aufweist;
   eine Steuereinrichtung (150), die ausgebildet ist, um die folgenden Steuerungen auszuführen:

   - Bereitstellen des Sollwertes,
   - Veranlassen des Änderungsmodus in der Einstellschaltung (130) in vorbestimmten Zeitabständen oder vor einer anstehenden Signalübertragung, um zwischen den aufeinanderfolgenden Pulsen eine Regelung des Ruhestromes vorzunehmen,
   - Veranlassen des Haltemodus in der Einstellschaltung (130),
   - Bereitstellen eines Steuersignals zur Überbrückung der Strommesseinrichtung (110) im Haltemodus.

2. Pulsverstärker nach Anspruch 1, die weiter eine Überbrückungsschaltung (140) umfasst, wobei die Überbrückungsschaltung (140) ausgebildet ist, um basierend auf einem Steuersignal die Strommesseinrichtung (110) zu überbrücken, so dass ein Strom in einem Betriebszustand des Galliumnitridtransistors (50) ohne durch die Strommesseinrichtung (110) durch den Galliumnitridtransistor (50) fließt.

3. Pulsverstärker nach Anspruch 1 oder Anspruch 2, wobei in dem Haltemodus die Einstellschaltung (130) ausgebildet ist, um einen zuvor an dem Steueranschluss (52) angelegten Spannungswert oder Stromwert in dem Ruhezustand zu halten, und in dem Änderungsmodus die Einstellschaltung (130) ausgebildet ist, um den Spannungswert und/oder den Stromwert zu ändern.

**4.** Pulsverstärker nach einem der vorhergehenden Ansprüche, wobei die Steuereinrichtung (150) ausgebildet ist, um den Änderungsmodus solange aufrecht zu halten, bis der Vergleich durch die Vergleichsschaltung (120) eine Übereinstimmung der erfassten Messgröße mit dem Sollwert innerhalb eines Toleranzbereiches liefert.

**5.** Pulsverstärker nach einem der vorhergehenden Ansprüche, wobei die Einstellschaltung (130) weiter einen Verstärker (132) umfasst, der ausgebildet ist, um den Spannungswert oder Stromwert auf ein gewünschtes Niveau zu verstärken.

**6.** Pulsverstärker nach einem der vorhergehenden Ansprüche, wobei die Strommesseinrichtung (110) einen Widerstand (112) mit einem vorbestimmten Widerstandswert (Rshunt) umfasst, so dass der Ruhestrom (Io) durch den Galliumnitridtransistor (50) als ein Spannungsabfall über den Widerstand (112) erfassbar ist.

**7.** Verfahren zur Regelung eines Ruhestromes (Io) durch einen Galliumnitridtransistor (50) eines Pulsverstärkers nach einem der Ansprüche 1 bis 6, wobei das Verfahren die folgenden Schritte umfasst:

Erfassen (S110) der Messgröße, die von dem Ruhestrom durch den Galliumnitridtransistor (50) zwischen dem Drain-Anschluss und dem Source-Anschluss abhängt;
Bereitstellen des Sollwertes;
Veranlassen des Änderungsmodus in vorbestimmten Zeitabständen oder vor der anstehenden Signalübertragung, um zwischen den aufeinanderfolgenden Pulsen die Regelung des Ruhestromes vorzunehmen; Vergleichen (S120) der erfassten Messgröße mit dem Sollwert;
Anlegen (S130), in dem Ruhezustand des Galliumnitridtransistors (50) und in Abhängigkeit von dem Vergleich, des Spannungswertes oder des Stromwertes an dem Steueranschluss (52), so dass der Ruhestrom (Io) durch den Galliumnitridtransistor (50) in dem Ruhezustand den gewünschten Wert aufweist;
Veranlassen des Haltemodus; und
Bereitstellen des Steuersignals zur Überbrückung der Strommesseinrichtung (110) im Haltemodus.

**Claims**

**1.** Pulse amplifier comprising at least one gallium nitride transistor (50) which has a drain terminal, a source terminal and a gate terminal as a control terminal (52), wherein the pulse amplifier is designed to amplify successive pulses having variable amplitude and, in order to eliminate memory effects, comprises an apparatus for regulating a quiescent current (Io) through the gallium nitride transistor (50), which apparatus comprises the following features:

a current measuring device (110) for detecting a measurement variable which depends on the quiescent current (Io) through the gallium nitride transistor (50) between a drain terminal and the source terminal;
a comparison circuit (120) for comparing the detected measurement variable with a target value;
an adjustment circuit (130) which can be operated in a change mode and in a hold mode and is designed to apply a voltage value or a current value to the control terminal (52) in a quiescent state of the gallium nitride transistor (50) on the basis of the comparison, such that the quiescent current (Io) through the gallium nitride transistor (50) in the quiescent state has a desired value;
a control device (150) which is designed to carry out the following controls:

- providing the target value,
- initiating the change mode in the adjustment circuit (130) at predetermined time intervals or before an upcoming signal transmission in order to regulate the quiescent current between the successive pulses,
- initiating the hold mode in the adjustment circuit (130),
- providing a control signal for bypassing the current measuring device (110) in the hold mode.

**2.** Pulse amplifier according to claim 1, further comprising a bypass circuit (140), wherein the bypass circuit (140) is designed to bypass the current measuring device (110) on the basis of a control signal, such that, in an operating state of the gallium nitride transistor (50), a current flows through the gallium nitride transistor (50) without flowing through the current measuring device (110).

**3.** Pulse amplifier according to either claim 1 or claim 2, wherein, in the hold mode, the adjustment circuit (130) is designed to hold a voltage value or current value previously applied to the control terminal (52) in the quiescent state, and, in the change mode, the adjustment circuit (130) is designed to change the voltage value and/or the current value.

4. Pulse amplifier according to any of the preceding claims, wherein the control device (150) is designed to maintain the change mode until the comparison by the comparison circuit (120) provides a match between the detected measurement variable and the target value within a tolerance range.

5. Pulse amplifier according to any of the preceding claims, wherein the adjustment circuit (130) further comprises an amplifier (132) which is designed to amplify the voltage value or current value to a desired level.

6. Pulse amplifier according to any of the preceding claims, wherein the current measuring device (110) comprises a resistor (112) having a predetermined resistance value (Rshunt), such that the quiescent current (Io) through the gallium nitride transistor (50) can be detected as a voltage drop across the resistor (112).

7. Method for regulating a quiescent current (Io) through a gallium nitride transistor (50) of a pulse amplifier according to any of claims 1 to 6, wherein the method comprises the following steps:

   detecting (S110) the measurement variable which depends on the quiescent current through the gallium nitride transistor (50) between the drain terminal and the source terminal;
   providing the target value;
   initiating the change mode at predetermined time intervals or before the upcoming signal transmission in order to regulate the quiescent current between the successive pulses;
   comparing (S120) the detected measurement variable with the target value;
   applying (S130) the voltage value or the current value to the control terminal (52) in the quiescent state of the gallium nitride transistor (50) and on the basis of the comparison, such that the quiescent current (Io) through the gallium nitride transistor (50) in the quiescent state has the desired value;
   initiating the hold mode; and
   providing the control signal for bypassing the current measuring device (110) in the hold mode.

**Revendications**

1. Amplificateur d'impulsions comportant au moins un transistor au nitrure de gallium (50) comportant une borne de drain, une borne de source et une borne de grille comme borne de commande (52), l'amplificateur d'impulsions étant conçu pour amplifier des impulsions successives d'amplitude variable et présentant un système de régulation d'un courant de repos (Io) à travers le transistor au nitrure de gallium (50) afin d'éliminer les effets de mémoire, le système comprenant les caractéristiques suivantes :

   un dispositif de mesure de courant (110) permettant d'enregistrer une grandeur de mesure qui dépend du courant de repos (Io) à travers le transistor au nitrure de gallium (50) entre une borne de drain et la borne de source ;
   un circuit de comparaison (120) permettant de comparer la grandeur de mesure enregistrée avec une valeur de consigne ;
   un circuit de réglage (130) qui peut fonctionner dans un mode de changement et dans un mode de maintien et qui est conçu pour appliquer une valeur de tension ou une valeur de courant à la borne de commande (52) dans un état de repos du transistor au nitrure de gallium (50) en fonction de la comparaison, de sorte que le courant de repos (Io) à travers le transistor au nitrure de gallium (50) présente une valeur souhaitée dans l'état de repos ;
   un dispositif de commande (150) conçu pour exécuter les commandes suivantes :

   - émission de la valeur de consigne,
   - initiation du mode de changement dans le circuit de réglage (130) à des intervalles prédéterminés ou avant une transmission de signal à venir, afin de réguler le courant de repos entre les impulsions successives,
   - déclenchement du mode de maintien dans le circuit de réglage (130),
   - émission d'un signal de commande afin de ponter le dispositif de mesure de courant (110) dans le mode de maintien.

2. Amplificateur d'impulsions selon la revendication 1, comprenant en outre un circuit de pontage (140), le circuit de pontage (140) étant conçu pour ponter le dispositif de mesure de courant (110) sur la base d'un signal de commande de sorte qu'un courant dans un état de fonctionnement du transistor au nitrure de gallium (50) traverse le transistor au nitrure de gallium (50) sans passer par le dispositif de mesure de courant (110).

3. Amplificateur d'impulsions selon la revendication 1 ou la revendication 2, dans lequel, dans le mode de maintien, le circuit de réglage (130) est conçu pour maintenir une valeur de tension ou une valeur de courant précédemment appliquée à la borne de commande (52) dans l'état de repos, et, dans le mode de changement, le circuit de réglage (130) est conçu pour changer la valeur de tension et/ou la valeur de courant.

4. Amplificateur d'impulsions selon l'une des revendications précédentes, dans lequel le dispositif de commande (150) est conçu pour maintenir le mode de changement jusqu'à ce que la comparaison par le circuit de comparaison (120) fournisse une correspondance entre la grandeur de mesure enregistrée et la valeur de consigne dans une plage de tolérance.

5. Amplificateur d'impulsions selon l'une des revendications précédentes, dans lequel le circuit de réglage (130) comprend en outre un amplificateur (132) qui est conçu pour amplifier la valeur de tension ou la valeur de courant à un niveau souhaité.

6. Amplificateur d'impulsions selon l'une des revendications précédentes, dans lequel le dispositif de mesure de courant (110) comprend une résistance (112) comportant une valeur de résistance prédéterminée (Rshunt), de sorte que le courant de repos (Io) à travers le transistor au nitrure de gallium (50) peut être enregistré comme une chute de tension au niveau de la résistance (112).

7. Procédé de régulation d'un courant de repos (Io) à travers un transistor au nitrure de gallium (50) d'un amplificateur d'impulsions selon l'une des revendications 1 à 6, le procédé comprenant les étapes suivantes :

enregistrement (S110) de la grandeur de mesure qui dépend du courant de repos à travers le transistor au nitrure de gallium (50) entre la borne de drain et la borne de source ;
émission de la valeur de consigne ;
initiation du mode de changement à des intervalles prédéterminés ou avant la transmission de signal à venir, afin de réguler le courant de repos entre les impulsions successives ;
comparaison (S120) de la grandeur de mesure enregistrée avec la valeur de consigne ;
application (S130), à l'état de repos du transistor au nitrure de gallium (50) et en fonction de la comparaison, de la valeur de tension ou de la valeur de courant à la borne de commande (52) de sorte que le courant de repos (Io) à travers le transistor au nitrure de gallium (50) présente la valeur souhaitée dans l'état de repos ;
déclenchement du mode de maintien ; et
émission d'un signal de commande afin de ponter le dispositif de mesure de courant (110) dans le mode de maintien.

Fig. 1

Fig. 2

Erfassen einer Messgröße, die von dem
Ruhestrom durch den Transistor abhängt

S110

Vergleichen der erfassten Messgröße
mit einem Sollwert

S120

Anlegen eines Spannungswert oder eines Stromwert
an dem Steueranschluss, so dass
der Ruhestrom durch den Transistor in dem
Ruhezustand einen gewünschten Wert aufweist

S130

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20030155978 A1
- WO 03063342 A1
- WO 2017044657 A1